(19)

**Europäisches Patentamt**
**European Patent Office**
**Office européen des brevets**

(11)  **EP 3 038 139 B1**

(12)  **EUROPEAN PATENT SPECIFICATION**

(45) Date of publication and mention
of the grant of the patent:
**27.01.2021   Bulletin 2021/04**

(51) Int Cl.:
*H01L 21/28* (2006.01)          *G11C 11/02* (2006.01)
*H01L 29/66* (2006.01)          *H01L 43/08* (2006.01)
*H01L 29/423* (2006.01)        *G11C 11/14* (2006.01)
*G11C 16/04* (2006.01)

(21) Application number: **14199656.1**

(22) Date of filing: **22.12.2014**

(54)  **Controllable conduction device**

**Bauelement mit einstellbarer Leitfähigkeit**

**Dispositif à conduction régulable**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**29.06.2016   Bulletin 2016/26**

(73) Proprietor: **Hitachi, Ltd.**
**Tokyo (JP)**

(72) Inventors:
  • **Wunderlich, Joerg**
    **Cambridge, Cambridgeshire CB30HE (GB)**
  • **Zalba, Fernando Gonzalez**
    **Cambridge, Cambridgeshire CB3 0HE (GB)**
  • **Ciccarelli, Chiara**
    **Cambridge, Cambridgeshire CB3 0HE (GB)**

  • **Jungwirth, Tomas**
    **Praha 6 (CZ)**
  • **Ferguson, Andrew**
    **Cambridge, Cambridgeshire CB3 0HE (GB)**
  • **Irvine, Andrew**
    **Cambridge, Cambridgeshire CB3 0HE (GB)**

(74) Representative: **Piotrowicz, Pawel Jan Andrzej et
al**
**Venner Shipley LLP**
**Byron House**
**Cambridge Business Park**
**Cowley Road**
**Cambridge CB4 0WZ (GB)**

(56) References cited:
**EP-A1- 2 068 350          US-A1- 2008 265 243
US-A1- 2010 182 837**

## Description

The present invention relates to a controllable conduction device, such as a field-effect transistor or a correlated charge transfer device.

In a field-effect transistor (FET), a gate electrode can be used to control conductivity of a channel running between source and drain electrodes.

In a correlated charge transfer device, such as a single-electron transistor (SET) or single-electron turnstile, transfer of an electron from source to drain lead via a small, weakly-coupled island can be inhibited by Coulomb blockade due to the charging energy, $E_C$, of the island. A gate electrode can be used to control the electrostatic energy of the island and, thus, select whether transfer of electrons is inhibited or not. In this way, the gate electrode can be used to control transfer of charge carriers between source and drain electrodes.

EP 2 068 350 A1 describes a floating gate non-volatile memory cell, with a floating gate comprising at least two layers constructed in different conductive or semiconductive materials.
US 2010/0182837 A1 describes a memory device including a floating gate element and a magnetic field generator that applies a magnetic field to the memory device. The magnetic field directs electrons in the memory device into the floating gate element. US 2008/0265243 A1 describes methods of forming ferromagnetic gate structures and devices including ferromagnetic floating gates formed with these methods.

A controllable conduction device can employ magnetically-ordered materials, such as ferromagnetic or antiferromagnetic materials, to provide further control over charge transport and to provide additional functions. EP 1830 410 A1 describes a correlated charge transfer device in which a source, a drain, island and/or gate comprises a ferromagnetic material and which exhibits a change in chemical potential in response to a change in direction of magnetisation. By changing the operating point of the device, the device can operate in one of two modes namely in electric mode, in which the device can operate as a single-electron transistor, and in a magnetic mode, in which it can operate as a memory device. EP 2 631 912 A1 describes a field-effect transistor having a non-magnetic channel and a gate which comprises a magnetically-ordered material.

Although such devices exhibit useful functionality, they are not particularly well-suited to being fabricated in semiconductor manufacturing plants. This is because magnetically-ordered materials tend to include transition metals which are seen as contaminants for silicon and other semiconductor materials.

Furthermore, there is scope for these devices to provide additional useful functionality.

## Summary

According to a first aspect of the present invention there is provided a controllable conduction device. The device comprises a conduction path and a floating gate for controlling flow of charge carriers along the conduction path. The floating gate comprises a first floating gate part and a second floating gate part. The first floating gate part which consists of a non-magnetically-ordered material and which is disposed closer to the conduction path than the second floating gate part. The second floating gate part which consists of a magnetically-ordered material (such as ferromagnetic material, antiferromagnetic material or ferrimagnetic material), which is disposed further away from the conduction path than the first floating gate part and which is conductively coupled to the first floating gate part. The magnetic controllable conduction also comprises a control electrode which consists of non-magnetically-ordered material and which is capacitively coupled to the second floating gate part.

Thus, a non-magnetic conduction control device, such as a field-effect transistor or a single-charge transistor, can be afforded magnetic functionality, for example the ability to store information magnetically, without significant structural modification. The magnetically-ordered part(s) of the device can be fabricated away from and/or before or after the other, non-magnetically-ordered parts of the device. This may help to avoid contamination of the non-magnetically-ordered parts of the device. Re-orientating magnetic moments in the second part of the floating gate causes a change in electrochemical potential in the first part of the floating gate and, thus, can remotely control conduction in the conduction path.

The device may comprise a gate dielectric interposed between the conduction path and the first part of the floating gate. The gate dielectric may comprise a layer of dielectric material, such as silicon dioxide (SiO2), silicon nitride ($Si_xN_y$), silicon oxinitride $SiO_xN_y$), hafnium oxide ($HfO_2$) or hafnium silicon oxynitride ($HfSiO_xNy$). The layer of dielectric material may have a thickness of at least 1 nm (for example, at least 2 nm for $HfO_2$), at least 2 nm, at least 5 nm, at least 10 nm, at least 20 nm or at least 50 nm.

The first floating gate part may comprise a semiconductor material, such as silicon (Si). The semiconductor material may be doped. The semiconductor material may be n-type or p-type. The semiconductor material may be doped to a concentration of at least $5 \times 10^{18}$ cm$^{-3}$, at least $1 \times 10^{19}$ cm$^{-3}$ or at least $2 \times 10^{19}$ cm$^{-3}$. A high doping concentration can help to form an ohmic contact with a metallic magnetically-ordered material. The first part of the floating gate may comprise polycrystalline silicon, for example N+ polysilicon or P+ polysilicon. The first part of the floating gate may comprise a metal, such aluminium (Al), or metal alloy. The control electrode may comprise titanium nitride (TiN).

The second floating gate part comprises a ferromagnetic material, an antiferromagnetic material or a ferrimagnetic material.

The ferromagnetic material may comprise a magnetic element, such as iron (Fe), nickel (Ni) or cobalt (Co). The ferromagnetic material may be an alloy of a magnetic element and a transition metal or a noble metal such as palladium (Pd), silver (Ag), iridium (Ir), platinum (Pt) or gold (Au). For example, the ferromagnetic alloy may be CoPt or FePt.

The antiferromagnetic material may comprise a magnetic element, such as manganese (Mn). The antiferromagnetic material may comprise an alloy of a magnetic element and a transition metal or a noble metal such as ruthenium (Ru), palladium (Pd), silver (Ag), iridium (Ir), platinum (Pt) or gold (Au). For example, the antiferromagnetic alloy may comprise IrMn, PtMn, AuMn, FeMn, $MnAs_{1-x}P_x$ or Au2Au.

The ferrimagnetic material may comprise an oxide. The ferrimagnetic material may be doped so as to increase conductivity. The ferrimagnetic material may comprise magnetite ($Fe_3O_4$).

The second part of the floating gate may comprise first and second magnetically-ordered materials which are exchange-coupled. The first magnetically-ordered material, such as ferromagnetic material or antiferromagnetic material, may comprise a material which exhibits a relatively large change in electrochemical potential when magnetic moments are re-orientated, but a relatively high value of coercivity and the second magnetically-ordered material, preferably a ferromagnetic material, may comprise a material which exhibits but a relatively low value of coercivity. Thus, the second magnetically-ordered material can be used to help re-orientate magnetic moments in the first magnetically-ordered material.

The first and second parts of the floating gate may be joined by an ohmic contact. The first and second parts of the floating gate may be joined through a junction at which is formed a tunnel barrier which is sufficiently thin that the junction exhibits ohmic characteristics.

The floating gate may comprise a third part which is interposed between the first and second parts. The third part of the floating gate may comprise a material for decreasing resistance of a junction between the first and second parts of the floating gate.

The floating gate may be elongate. The floating gate may run laterally, away from the conductive path. The floating gate may have first and second ends and a length between the first and second ends. The first end may face the conductive path. The length may be at least 20 nm, at least 50 nm, at least 100 nm. The length may be at least 200 nm, at least 500 nm, or at least 1 $\mu$m.

The control electrode may comprise a semiconductor material, such as silicon (Si). The semiconductor material may be doped. The semiconductor material may be n-type or p-type. The semiconductor material may be doped to a concentration of at least $5 \times 10^{18}$ cm$^{-3}$, at least $1 \times 10^{19}$ cm$^{-3}$ or at least $2 \times 10^{19}$ cm$^{-3}$. The control electrode may comprise polycrystalline silicon, for example N+ polysilicon or P+ polysilicon. The control electrode may comprise a metal, such aluminium (Al), or metal alloy. The control electrode may comprise titanium nitride (TiN).

The device may comprise a control electrode dielectric interposed between the floating gate and the control electrode. The gate dielectric may comprise a layer of dielectric material, such as silicon dioxide ($SiO_2$), silicon nitride ($Si_xN_y$), silicon oxinitride $SiO_xN_y$), hafnium oxide ($HfO_2$) or hafnium silicon oxynitride ($HfSiO_xNy$). The layer of dielectric material may have a thickness of at least 1 nm (for example, at least 2 nm for HfO2), at least 2 nm, at least 5 nm, at least 10 nm, at least 20 nm or at least 50 nm

The conductive path may comprise a semiconductor material, such as silicon. The semiconductor material may be doped. The semiconductor material may be n-type or p-type.

The conduction control device may be a field-effect transistor. The conductive path may be continuous. The conductive path may be doped to a concentration no more than $2 \times 10^{17}$ cm$^{-3}$, no more than $1 \times 10^{17}$cm$^{-3}$ or no more than $5 \times 10^{16}$ cm$^{-3}$.

The field-effect transistor may be a junctionless field-effect transistor and the conductive path may be doped to a concentration of no more than $5 \times 10^{18}$ cm$^{-3}$.

The conduction control device may be a correlated charge transfer device, such as a single-charge transistor. The conductive path may be broken up into one or more conductive islands. The conductive path may be doped to a concentration if at least $1 \times 10^{18}$ cm$^{-3}$, at least $2 \times 10^{18}$ cm$^{-3}$ or at least $5 \times 10^{18}$ cm$^{-3}$. The conductive path may at include a section having a thickness and/or width no more than 50 nm, no more than 20 nm or no more than 10 nm. Thus, the conductive path may comprise a thin and/or narrow section of highly-doped semiconductor material which, due to depletion, results in the formation of conductive islands separated by depleted regions of semiconductor material.

The controllable conduction device may comprise at least one further gate electrode for controlling flow of charge carriers along the conduction path. The at least one further gate electrode may comprise a non-magnetically-ordered material.

The controllable conduction device may be configured to exhibit non-monotonic behaviour of conductance with gate voltage. The device may comprise a correlated charge transfer device, such as a single-charge transistor. The single-charge transistor may be a single-electron transistor. The single-charge transistor may be a single atom transistor. The device may be an ambipolar device. The ambipolar device may be a carbon nanotube field-effect transistor or graphene transistor.

According to a second aspect of the present invention there is provided a circuit comprising at least two conduction control devices which share a common floating gate part which comprises magnetically-ordered material.

**Brief Description of the Drawings**

Certain embodiments of the present invention will now be described, by way of example, with reference to the accompanying drawings, in which:

Figure 1 schematically illustrates a magnetic controllable conduction device;
Figure 2 schematically illustrates the magnetic controllable conduction device shown in Figure 1 including a region of magnetically-ordered material;
Figure 3 schematically illustrates a magnetic controllable conduction device comprising a control electrode and a floating gate;
Figure 4 schematically illustrates reconfigurable logic circuit having retainable (i.e. non-volatile) logic function;
Figure 5 shows a single-electron transistor having a magnetically-ordered gate;
Figure 6 is a plot of conductance G against gate voltage $V_G$ for the single-electron transistor shown in Figure 5;
Figure 7 illustrates dependency of output state on input state for the single-electron transistor shown in Figure 5;
Figure 8 schematically illustrates a first reconfigurable logic circuit;
Figures 9a and 9b show source-drain voltage-gate-source voltage diagrams for the first reconfigurable logic circuit shown in Figure 8 at different operating points;
Figure 10 shows a second reconfigurable logic circuit comprising four single-electron transistors and which is selectively operable as a NAND gate or an OR gate;
Figure 11a is a truth table for a NAND gate;
Figure 11b is a truth table for an OR gate;
Figure 12 shows a third reconfigurable logic circuit comprising two single-electron transistors and a resistor, and which is selectively operable as a NAND gate or OR gate;
Figure 13 shows a fourth reconfigurable logic circuit comprising two single-electron transistors and a resistor, and which is selectively operable as an OR gate or a NAND gate;
Figure 14 illustrates implementation of two series-connected single-electron transistors using a common, magnetically-ordered gate;
Figure 15 illustrates implementation of two parallel-connected single-electron transistors using a common, magnetically-ordered gate;
Figure 16 shows a fifth reconfigurable logic circuit comprising a single-electron transistor having two gate electrodes;
Figure 17a is a truth table for an XOR gate;
Figure 17b is a truth table for a XNOR gate;
Figure 18a shows a conductance plot when the fifth reconfigurable logic circuit is operating as an XOR gate;
Figure 18b shows a conductance plot when the fifth reconfigurable logic circuit is operating as an XNOR gate;
Figure 19 illustrates behaviour of a magnetic field-effect transistor depending on orientation of magnetic moments in a magnetically-ordered gate;
Figure 20 shows a reconfigurable inverter;
Figure 21 is a truth table for the reconfigurable inverter shown in Figure 20;
Figure 22 schematically illustrates a magnetic controllable conduction device comprising a control electrode and a floating gate which includes a first part consisting of non-magnetically-ordered material which is disposed next to a conductive path and a second part consisting of magnetically-ordered material which is disposed away from the conductive path, but which is conductively coupled to the first part of the floating gate;
Figure 23 is an equivalent circuit for the arrangement shown in Figure 22;
Figure 24a is a plot of chemical potential along the structure shown in Figure 23;
Figure 24b is a plot of electrical potential along the structure shown in Figure 23;
Figure 24c is a plot of electrochemical potential along the structure shown in Figure 23;
Figure 24d is a plot of charge accumulation along the structure shown in Figure 23; and
Figure 25 is a process flow diagram of fabricating a magnetic transistor or a circuit including a magnetic transistor.

**Detailed Description of Certain Embodiments**

Magnetic controllable conduction device 1

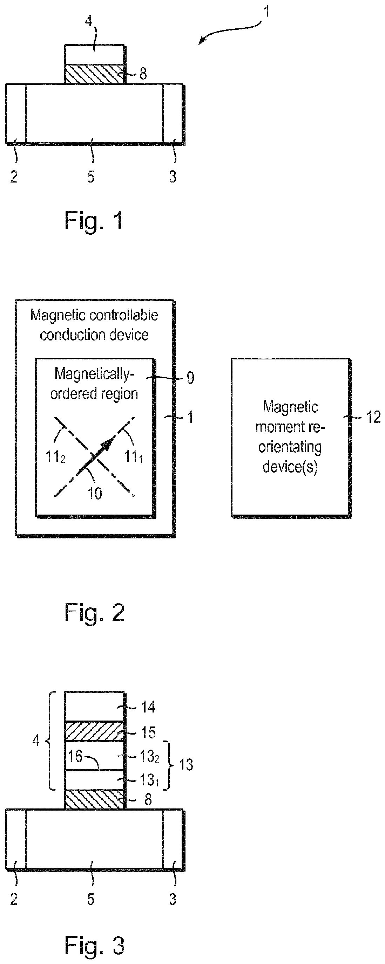

Referring to Figure 1, a magnetic controllable conduction device 1 (or "magnetic transistor") is shown.

The device 1 has at least three electrodes 2, 3, 4, including first and second contact electrodes 2, 3 and at least one gate electrode 4, and a conductive path 5 (herein also referred to as "channel") between the first and second contact electrodes 2, 3 (herein also referred to as "source" and "drain" respectively).

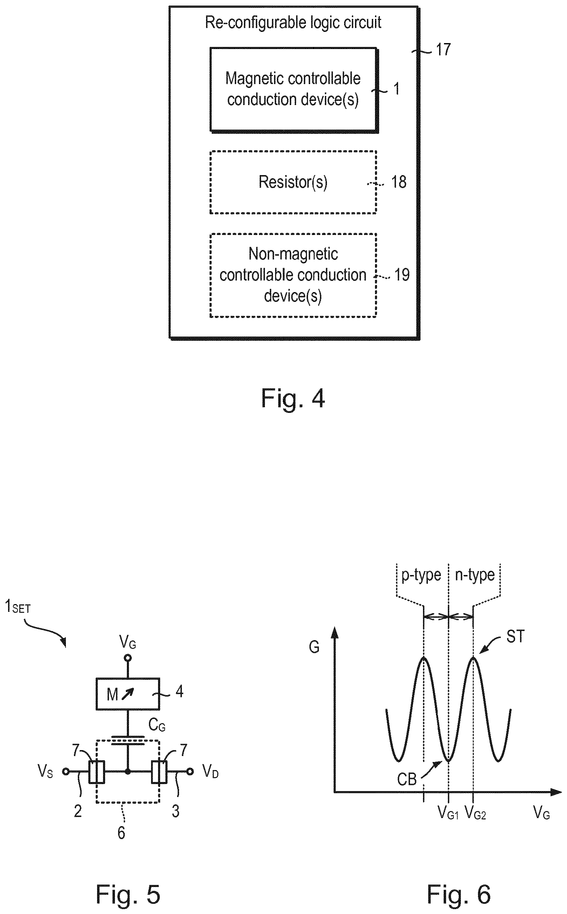

The gate electrode(s) 4 control the flow of charge carriers in the channel 5. The conductive path 5 may be continuous, such as in a field-effect transistor, or may be divided up into one or more discrete conductive regions 6 (Figure 5) (herein referred to as "conductive islands") by two or more tunnel barriers 7 (Figure 5), such as in a single-electron transistor or single atom transistor. The, or each, gate electrode 4 may be separated from the conductive path 5 by a region 8 of dielectric material (which may be referred to simply as the "gate dielectric").

Referring also to Figure 2, the magnetic controllable conduction device 1 has at least one region 9 of magnetically-ordered material whose chemical potential depends on orientation of magnetic moments 10. The magnetically-ordered material may be a ferromagnetic material, a ferrimagnetic material or an antiferromagnetic material. Magnetic moments 10 in the magnetically-ordered region 9 are switchable between two or more non-collinear remnant orientations $11_1$, $11_2$ (or "magnetic easy axes") corresponding to two or more different device states. Non-volatile logic function arises due to stable orientation of magnetic moments 10 along magnetic easy axes $11_1$, $11_2$ without applying external magnetic fields or electrical currents.

One or more magnetic moment re-orientating device 12 is (are) used for re-configuring the magnetic transistor 1.

A magnetic moment re-orientating device 12 may comprise a magnetic field source for applying a magnetic field in a first or second direction for re-orientating the alignment of magnetic moments 10. A magnetic moment re-orientating device 12 may comprise a bias source for applying a voltage across the device the magnetically-ordered region 9 for generating a spin-Hall effect. A magnetic moment re-orientating device 12 may comprise a bias source for driving a spin-torque transfer current of spin-orbit torque through the magnetically-ordered region 9. A magnetic moment re-orientating device 12 may comprise a bias source and a gate for applying a precession-inducing electric field pulse to the the magnetically-ordered region 9. A magnetic moment re-orientating device 12 may comprise a optical source, such as laser, for applying a light pulse to the magnetically-ordered region 9.

Each device 1 may be provided with a respective magnetic moment re-orientating device 12. For example, a device 1 may be provided with a respective bias source or may be individually addressable by a common bias source. Additionally or alternatively, more than one device 1 may be provided with a shared respective magnetic moment re-orientating device 12, such as a magnetic field source.

A gate electrode 4 may consist of a magnetically-ordered material thereby providing the region 9 of magnetically-ordered material. However, as shown in Figure 3, the gate electrode 4 may comprise a floating gate 13 and a control electrode 14 separated from the floating gate 13 by a layer 15 of dielectric material (which may be referred to simply as the "control gate dielectric" or even "control dielectric").

Referring to Figure 3, the floating gate 13 includes a first part $13_1$ consisting of non-magnetically-ordered material which is disposed proximate to, e.g. next to, the conductive path 5 and a second part $13_2$ consisting of magnetically-ordered material which is disposed away from the conductive path 5, but which is conductively coupled (for example, directly coupled via a junction 16) to the first part $13_1$ of the floating gate 13. Even though the second part $13_2$ of the floating gate 13 is remotely located, changes in orientation of magnetic moments 10 (Figure 2) in the second part $13_2$ of the floating gate 13 can cause a change in electrochemical potential in the first part $13_1$ of the floating gate 13 and, thus, can remotely control conduction in the conductive path 5.

A magnetic controllable conduction device 1 may take the form of a magnetic field-effect transistor (MFET) in which switching orientation of magnetic moments in a magnetically-ordered gate electrode or a magnetically-ordered part of a gate electrode causes the transistor to switch from ON state to an OFF state or *vice versa.*

A magnetic controllable conduction device 1 may take the form of a magnetic single-electron transistor (MSET) in which switching orientation of magnetic moments in a magnetically-ordered gate electrode or a magnetically-ordered part of a gate elect causes the device to switch the device from p-type transistor mode to n-type transistor mode.

Reconfigurable logic circuit 17

Referring to Figure 4, Boolean logic functions can be realized in a logic circuit 17 using one or more magnetic controllable conduction devices 1 and, optionally, one or more resistive elements 18 and/or one or more non-magnetic controllable conduction devices 19 (herein also referred to as "non-magnetic transistors"), such as complementary metal-oxide-semiconductor (CMOS) transistors. The logic functions can be programmed and be retained, i.e. the logic is non-volatile.

Magnetic controllable conduction devices 1 in conjunction with non-magnetic controllable conduction devices 19 can be used to reconfigurably modify and/or extend functionality of the non-magnetic controllable conduction devices 19. Furthermore, if the magnetic controllable conduction devices 1 take the form of magnetic single-electron transistors, then this can facilitate energy management.

The magnetic controllable conduction device(s) 1 can operate in an electric mode in which conductivity (or resistance) of the conductive path 5 (Figure 1) is affected by a gate voltage, $V_G$, and/or in a magnetic mode, in which the conductivity (or resistance) of the conductive path 5 depends on the orientation of magnetic moments 10 (Figure 2).

The electric and magnetic modes of operation allow magnetic controllable conduction device(s) 1 to be form reconfigurable Boolean logic function gates.

Magnetic controllable conduction device behaviour

A change in orientation of magnetic moments 10 (Figure 2) can produce a change in the chemical potential of a magnetically-ordered region (herein simply referred to as a "magnetic region" or "magnetic layer") of a gate electrode 4 (Figure 1) which can induce charge accumulation in the gate electrode 4. Charge accumulation can be sensed by or in a field-effect device, such a field-effect transistor or a single-electron transistor. The net effect of the magnetization reorientation in the magnetic region is to produce a voltage shift in the current characteristics of magnetically-gated devices. If the chemical potential shift of the gate electrode is sufficiently large, the transfer curves of the field-effect device can be dramatically altered.

In some forms of devices (herein referred to as "symmetric devices"), a change in orientation of magnetic moments 10 (Figure 1) can cause a device to switch from exhibiting n-type device behaviour to p-type device behaviour and so provide complementary types of device behaviour in the same device. For example, in an n-type device, an output current is low ('0') when an input voltage is low ('o') and the output current is high ('1') when the input voltage is high ('1'). By re-orientating magnetic moments, the outputs can be inverted resulting in a high current output ('1') for a low voltage input ('0') and a low current output ('o') for a high voltage input ('1'). Symmetric controllable conduction devices include those devices which exhibit a non-monotonic (e.g. periodic) variation in conductance with gate voltage, such as single-electron transistors, single-atom transistors and ambipolar devices, such as carbon nanotube field-effect transistors and graphene transistors.

In other forms of devices (herein referred to as "asymmetric device"), a change in orientation of magnetic moments can cause a device to switch between ON and OFF states or to cause a shift from an input-sensitive working point to an input- insensitive working point. Asymmetrical controllable conduction devices include a field-effect transistor with a magnetically-ordered gate electrode.

Both types of device can employ a gate electrode 4 (Figure 1) which comprises a local or remote region of magnetically-ordered material. Some magnetically-ordered materials can exhibit a change of chemical potential of the order of 100 meV or more due to a change in orientation of magnetic moments. For example, in a structure comprising a stack of platinum (Pt), manganese oxide (MgO), iridium manganese (IrMn) and tantalum (Ta), re-orientation of magnetic moments in the antiferromagnetic IrMn layer can result in a change of chemical potential of about 150 meV. The magnetically-ordered material need not be antiferromagnetic, but can be, for example, ferrimagnetic. Furthermore, a magnetically-ordered region may be provided with adjacent layer(s) of magnetically-polarisable heavy transition metals, rare earth materials and/or oxide tunnelling barriers, which can help to increase the change in chemical potential.

In the following, a magnetic single-electron transistor is used as an example of a symmetric magnetic controllable conduction device and a magnetic field-effect transistor is used as an example of an asymmetric magnetic controllable conduction device.

*Magnetic single-electron transistor 1$_{SET}$*

Magnetic single-electron transistors exhibiting Coulomb blockade anisotropy magnetoresistance (CBAMR) are described in EP 1830 410 A1, the contents of which is incorporated herein by reference.

Referring to Figure 5, a magnetic single-electron transistor $1_{SET}$ comprises non-magnetic (i.e. non-magnetically-ordered) source and drain electrodes 2, 3, a magnetic gate electrode 4 and a non-magnetic island 6 separated from the source and drain electrodes 2, 3 by tunnel barriers 7. Such a magnetic single-electron transistor $1_{SET}$ can be implemented by forming the source and drain electrodes 2, 3 and island 6 on a surface of an insulating substrate (not shown) and forming a magnetic back gate 4, i.e. a gate on the opposite surface of the substrate.

Referring also to Figure 6, the magnetic gate electrode 4 (which in this case comprises a ferromagnetic material) is electrostatically coupled to the island 6. The electrode 4 can change the electrostatic energy of the island 6 and can vary conductance G of the device $1_{SET}$ between being in an open, sequential tunnelling regime (ST) to a closed, Coulomb blockade regime (CB) and between having p-type gating characteristics (in which there is a reduction in conductance G with increasing gate voltage $V_G$) and n-type gating characteristics (in which there is an increase in conductance with gate voltage $V_G$).

The electrochemical gate potential $\mu_G^{el-ch}$ is defined by a gate bias voltage, namely $\mu_G^{el-ch} = eV_G$, where e is the elementary charge ($1.602 \times 10^{-19}$ C) and $V_G$ is the gate voltage. If there is a change in orientation of magnetization M at fixed gate bias $V_G$, then there is a change in electrical potential corresponding to the magnetization-dependent chemical gate potential variation $\Delta\mu_G^{el} = eV_G - \Delta\mu_G^{ch}$ and there is a change in conductance G of the magnetic single-electron transistor $1_{SET}$ corresponding to the variation in gate bias voltage $\Delta V_G = \Delta\mu_G^{ch}/e$ for unchanged magnetization. Therefore, the working point the transistor $1_{SET}$ can be changed by varying the gate magnetisation orientation. This effect is observable in ferrimagnetic and antiferromagnetic gates in which magnetization orientations of antiferromagnetically-coupled sub-lattices can be changed.

A maximum change in electrical potential between low-conductance, Coulomb blockage regime (CB) to high-conductance, sequential tunnelling regime (ST) is given by:

$$\Delta\mu_{max} = e^2/2C_G \qquad\qquad (1)$$

To enable complementary single-electron transistor operation at a non-zero temperature T, a minimum change in electrical potential is given by:

$$\Delta\mu_{min} = 4.35\ k_B.T.C_\Sigma.e^2/C_G \qquad\qquad (2)$$

where $k_B$ is the Boltzmann constant ($1.3806 \times 10^{-23}$ J/K) and $C_\Sigma$ is the total capacitance of the island 6.

Thus, the single-electron transistor $1_{SET}$ can operate in a magnetic mode and can switch between n-type and p-type gating behaviour when the chemical potential variation $\Delta\mu$ is larger than $\Delta\mu_{min}$.

*Magnetic field-effect transistor $1_{FET}$*

Magnetic field-effect transistors $1_{FET}$ a magnetically-ordered gate electrode can be switched between ON and OFF states by reorienting magnetic moments of the magnetic gate electrode. This is possible when magnetic anisotropy in chemical potential is large enough to switch the threshold gate bias by $\Delta V_G^{THR} \sim 2\ k_b.T/e$ or larger (where $k_B$ is the Boltzmann constant, T is the operation temperature and e is elementary charge). $\Delta V_G^{THR}$ should be larger than the fluctuation between the device-specific $V_G^{THR}$ of all the magnetic field-effect transistors $1_{FET}$ in the same circuit 17.

Reconfigurable logic circuits containing magnetic single-electron transistors

Magnetic single-electron transistors alone (i.e. without magnetic field-effect transistors) can be used to realize reconfigurable logic functions.

As will be described in more detail later, magnetic single-electron transistors can be used to realize a NAND logic function which is reconfigurable into an OR logic function by switching two possible magnetic moment orientation $\uparrow$ and $\leftarrow$ into $\leftarrow$ and $\uparrow$ respectively. Similarly, magnetic single-electron transistors can be used to realize NOR logic function which can be magnetically switched into an AND logic function. It is noted that NAND and NOR functions provide a functionally complete set of logical connectives which can be used to express all possible truth tables.

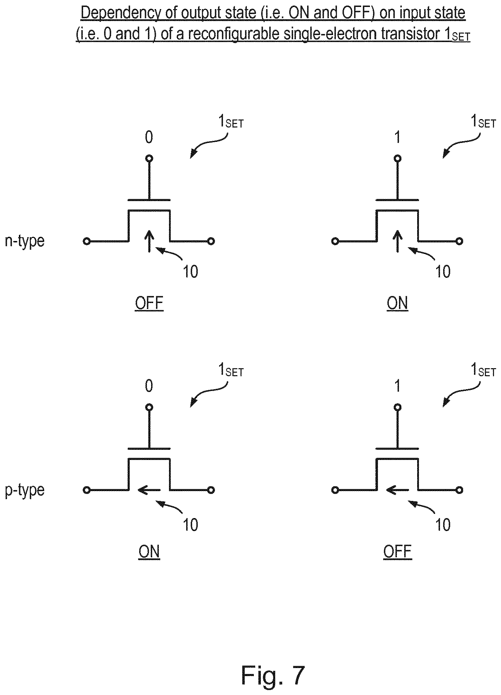

Figure 7 shows the output state, i.e. ON or OFF, of a magnetic single-electron transistor $1_{SET}$ for different orientations of magnetic moments 10, namely $\uparrow$ and $\leftarrow$ orientations respectively.

Although a circuit symbol for a MOSFET is used in Figure 7, the device shown in Figure 7 is a single-electron transistor $1_{SET}$ having a channel which includes at least one conductive island and at least two tunnel barriers interposed between the source and drain.

Also, although the symbols "$\uparrow$" and "$\leftarrow$" are used for indicating different stable orientations of magnetic moments, the orientations need not specifically be directed in the these directions, i.e. up and to the left, and need not be at right-angles (i.e. 90°) to each other. It will be understood that magnetic moments may be anti-parallel in some magnetically-ordered materials, such as antiferromagnetic materials, and so the orientation corresponds to an axis along which some magnetic moments may be parallel and other magnetic moments may be antiparallel.

Reconfigurable logic circuit using one single-electron transistors

Reconfigurable retainable logic can be implemented with as few as one single-electron transistors.

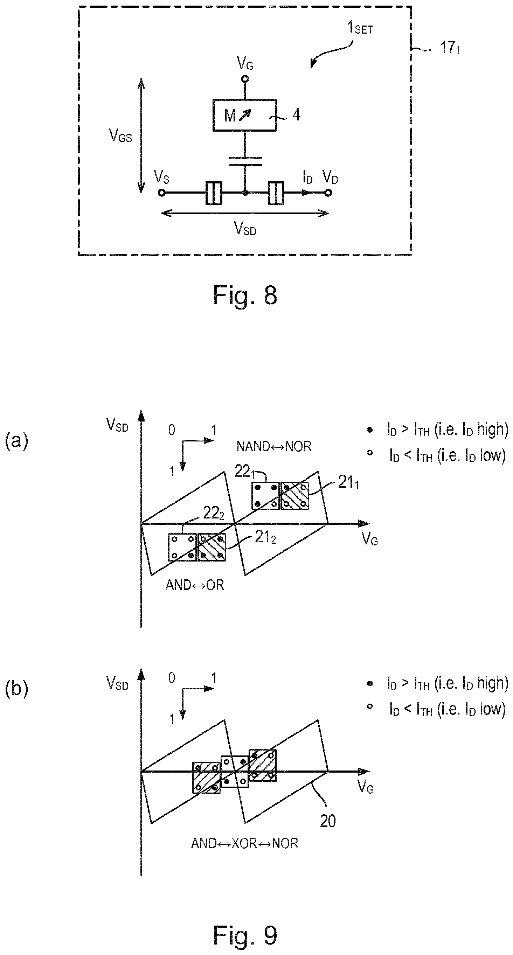

Referring to Figure 8, logic inputs for a first, single-transistor logic circuit $17_1$, i.e. a logic circuit consisting of one single-electron transistor $1_{SET}$, are the drain voltage $V_D$ and the gate voltage Vs and the output is the drain current $I_D$.

Figures 9a and 9b show a source-drain voltage - source-gate voltage ($V_{DS}$ - $V_{GS}$) diagrams exhibiting Coulomb diamonds 20 for the first logic circuit $17_1$. Figures 9a and 9b also show a logic gate 21, 22 in different states with four sets of inputs represented as filled and unfilled dots. An unfilled dot corresponds to logical '0' (i.e. a relatively low current level) and a filled dot corresponds to a logical '1' (high current level).

In a single electron transistor $1_{SET}$ (Figure 8), the current level is used as an output and the source-drain voltage and gate voltage as inputs. The logic gates are implemented at the edges of the Coulomb diamonds 20 in the current map. Each square 21,22 defines four possible voltage combinations of a logic gate as dots. Each pair of reconfigurable logic gates use two gate voltage values and two source-drain voltage values. These are chosen at different points in the current map depending on the set of gates to implement. The output is considered to be a logic '1' when the current is above certain threshold value $I_{th}$ (marked by full dots) and a logic '0' when the current is below $I_{th}$. The logic gates $21_1$, $21_2$ (i.e. shown shaded) are implement for a first remnant orientation of the magnetic moments 10 (Figure 2) in the magnetically-ordered region 9 (Figure 2) and the logic gates $22_1$, $22_2$ (i.e. shown un- shaded) are for a second, different remnant orientation (in this case, with a higher chemical potential thereby producing a positive voltage shift) using the same voltage inputs.

Figure 9a shows logic reconfigurable between NOR-NAND AND-OR gates. NAND-NOR gates use two positive source-drain voltage values whereas AND-OR gates use two negative source-drain voltage values.

Referring to Figure 9a, logic gate in first states $21_1$, $21_2$ represent values for a first orientation of the magnetization. Re-orientation of the magnetization into a second orientation shifts the gate logic inputs towards lower gate voltages and results in a change in logic gate functionality. Thus, a NOR gate can be reconfigured to be a NAND gate and an OR gate can be reconfigured to be an AND gate.

Figure 9a shows a reconfigurable gate that cab switch between AND-XOR or XOR-NOR if only two remnant orientations of magnetic moments 10 (e.g. two remnant magnetizations) are possible or switch between AND-XOR-NOR if three remnant orientations of magnetic moments 10 are possible. In this case, one positive and one negative source-drain voltage input are used.

Referring to Figure 9b, in the same way, if the source-drain voltage offset is reduced, then reconfiguration can be achieved going from NOR to XOR and from XOR to AND.

Reconfigurable logic circuit using single-electron transistors

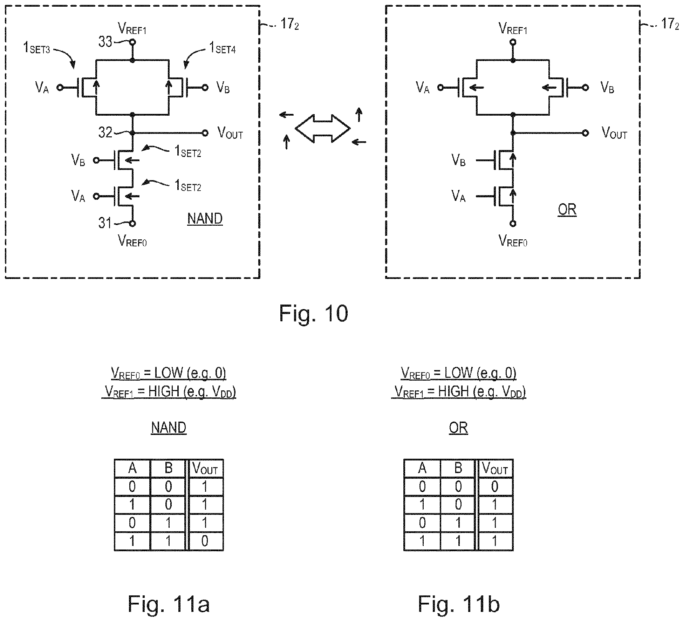

Figure 10 shows a second reconfigurable logic circuit $17_2$ which consists of first, second, third and fourth single-electron transistors $1_{SET1}$, $1_{SET2}$, $1_{SET3}$, $1_{SET4}$ which, when magnetic moments 10 are arranged in a first set of orientations ("first state"), is operable as an OR gate and, when magnetic moments 10 are arranged in a second set of orientations ("second state"), is operable as an NAND gate.

Referring to Figure 10, first and second magnetic single-electron transistors $1_{SET1}$, $1_{SET2}$ are connected in series between a first terminal 31 to which a first reference voltages $V_{G0}$ is applied and a tap 32 which provides an output $V_{OUT}$. Magnetic moments in the first and second transistors $1_{SET1}$, $1_{SET2}$ are orientated such that the first and second transistors $1_{SET1}$, $1_{SET2}$ have the same type of polarity gating behaviour, e.g. p-type gating behaviour.

Third and fourth magnetic single-electron transistors $1_{SET3}$, $1_{SET4}$ are connected with in parallel between the tap 32 and a second terminal 33 to which a second reference voltage $V_{G2}$ is applied. Magnetic moments in the third and fourth transistors $1_{SET31}$, $1_{SET4}$ are orientated such that the third and fourth transistors $1_{SET3}$, $1_{SET4}$ have the same type of polarity gating behaviour, but opposite to that of the first and second transistors $1_{SET1}$, $1_{SET2}$, e.g. n-type gating behaviour.

The first and second transistors $1_{SET1}$, $1_{SET2}$ and third and fourth transistors $1_{SET3}$, $1_{SET4}$ can be set to be of different polarity by, for example, being p-type and n-type respectively, at a given operating point. In that case, a common magnetic gate can be used to switch the transistors between exhibiting p-type gating behaviour and n-type gating behaviour.

Alternatively, the transistors may be of the same polarity type, but the first and second transistors $1_{SET1}$, $1_{SET2}$ are gated by a first common magnetic gate having a first orientation of magnetic moments and the third and fourth transistors $1_{SET3}$, $1_{SET4}$ are gated by s second common magnetic gate having a second orientation of magnetic moments. The first and second magnetic gates may be exchanged coupled so that the first and second orientations are anti-parallel.

In the NAND state, the reference signals $V_{REF0}$ and $V_{REF1}$ are set to '0' and '1' (or "LOW and "HIGH") respectively.

Figure 11a shows a truth table for logic circuit $17_2$ in the first state, i.e. NAND. Figure 11b shows a truth table for logic circuit $17_2$ in the second state, i.e. OR

The circuit $17_2$ can be switched from the OR state to the NAND state by changing the reference signals $V_{G0}$ and $V_{G1}$ to logic '1' and logic '0' respectively.

Reconfigurable logic circuit using single-electron transistors and resistors

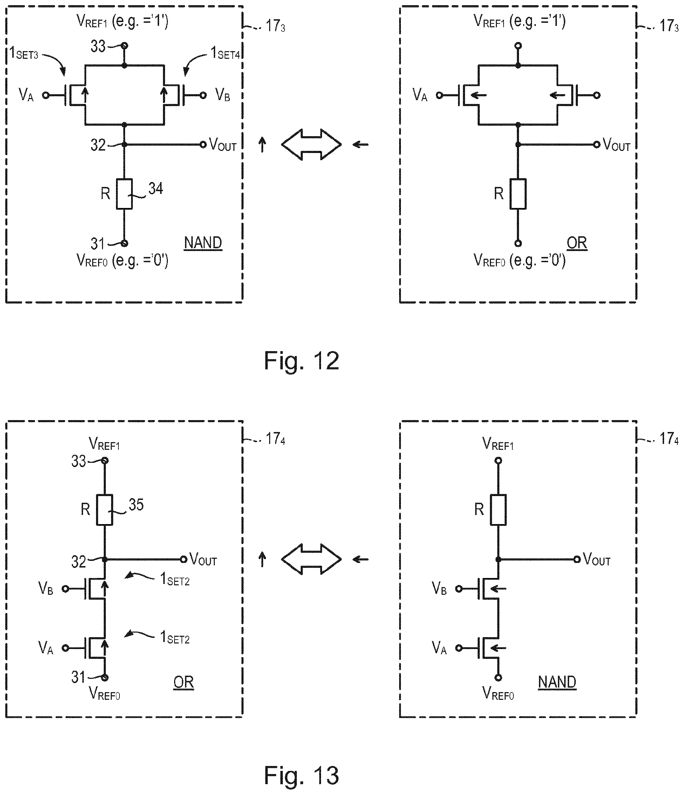

Figure 12 shows a third reconfigurable logic circuit $17_3$. The third reconfigurable logic circuit $17_3$ is the same as the second reconfigurable logic circuit $17_2$ except that the first and second first and second transistors $1_{SET1}$, $1_{SET2}$ are replaced by a resistor 34.

Figure 13 shows a fourth reconfigurable logic circuit $17_4$. The fourth reconfigurable logic circuit $17_4$ is the same as the second reconfigurable logic circuit $17_2$ except that the third and fourth first and second transistors $1_{SET3}$, $1_{SET4}$ are replaced by a resistor 35.

The third and fourth reconfigurable logic circuits $17_3$ $17_4$ are operated in the same way as the second reconfigurable logic circuit $17_2$, although additional power is dissipated by the resistor 34, 35 and account should be taken of the RC time constant when operating the logic circuit at high speeds.

The value of resistance R of the resistor 34, 35 is chosen to be significantly larger than the effective resistance of the transistors when open and significantly lower than the effective resistances of the transistors when closed.

Reconfigurable logic circuit using single-electron transistors and common gates

Referring again to Figure 5, it is possible for a gate electrode 4 to be located remotely (e.g. > 100 nm) from the rest of a single-electron transistor $1_{SET}$ since the gate electrode 4 and the island 6 need only be capacitively coupled. For example, the contact electrodes 2, 3 and island 6 may be formed in a layer of silicon (not shown), the gate electrode 4 may be provided by a silicon substrate (no shown) and the two parts of the device are separated by a buried layer of silicon dioxide (not shown). Alternatively, the gate electrode 4 may be provided as a top electrode.

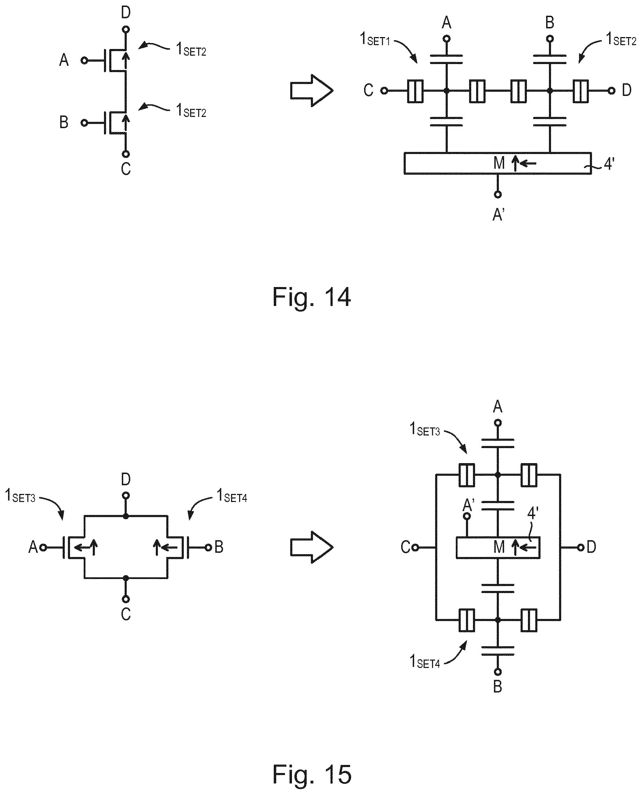

Referring to Figure 14, the first and second transistors $1_{SET1}$, $1_{SET2}$ can be implemented using a common gate 4', which may take the form of a back- or top-gate, consisting of magnetically-ordered material.

Referring to Figure 15, the third and fourth transistors $1_{SET3}$, $1_{SET4}$ can be implemented using a common gate 4', which may take the form of a back- or top-gate, consisting of magnetically-ordered material.

As shown in Figures 14 and 14, individual single-electron transistors $1_{SET1}$, $1_{SET2}$, $1_{SET3}$, $1_{SET4}$ may include respective second gate, which may take the form of a side or a local top- or back-gate, to control the transistors $1_{SET1}$, $1_{SET2}$, $1_{SET3}$, $1_{SET4}$ individually.

Reconfigurable logic circuit realizing XOR and XNOR using one single-electron transistor having at least one magnetic gate, another non-magnetic gate and a resistor

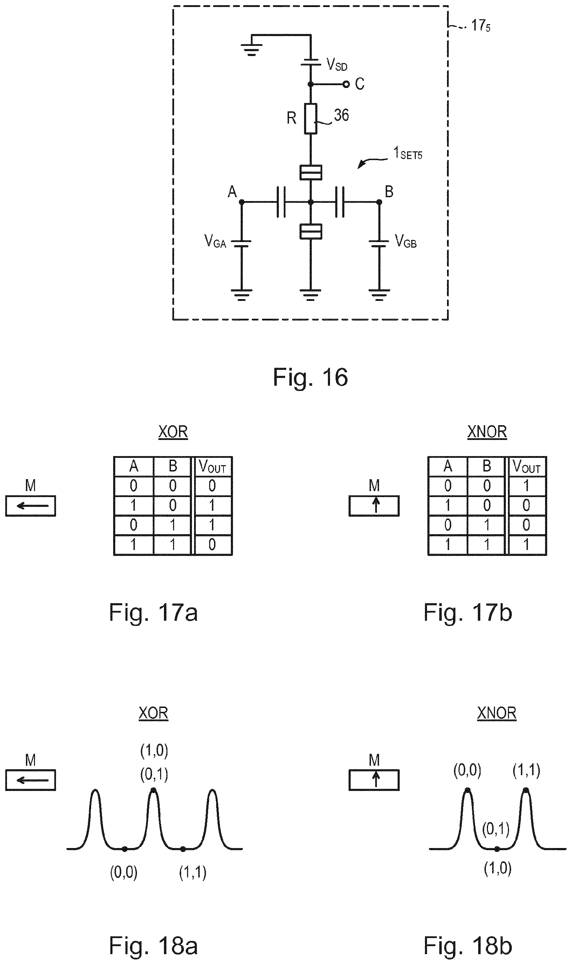

Figure 16 shows a fifth reconfigurable logic circuit $17_5$. The fifth reconfigurable logic circuit $17_5$ contains one single-electron transistor $1_{SET5}$ having first and second gate electrodes $4_1$, $4_2$, one of which is, or contains, a magnetically-ordered region.

In combination with a resistor 36, the one single-electron transistor $1_{SET5}$ can be used to selectively provide XOR and XNOR functions.

Referring also to Figures 17a, 17b, 18a and 18b, applying logic '1' bias on input A or B corresponds to half of a full Coulomb oscillation and so switches the single-electron transistor $1_{SET5}$ from Coulomb blockade regime into sequential tunnelling regime or *vice versa.*

The change of chemical potential due to magnetization reorientation between $\uparrow$ and $\leftarrow$ is of the same magnitude as the electrical logic '1' bias potential on input A or B.

Programmable logic using magnetic field-effect transistors

Referring again to Figure 1, a magnetic field-effect transistor 1 comprises source and drain electrodes 2, 3 providing contacts to a conductive channel 5 formed of non-magnetically-ordered material, a gate electrode 4 for applying an electric field to the channel 5 and a gate dielectric 8 separating the gate electrode 4 from the channel 5.

The gate electrode 4 next to the channel 5 comprises is formed from a magnetically-ordered material having a chemical potential which depends on orientation of the magnetic moments 10 (Figure 2) in the gate electrode 4. Thus, orientation of magnetic moments 10 in the gate region can be used to control charge transport in the conductive channel 5. The channel 5 may be of n- or p-charge carrier type.

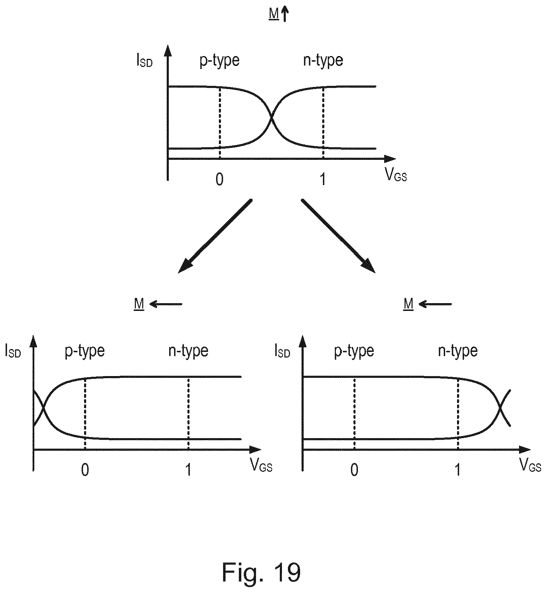

Figure 19 shows how logic inputs '0' and '1' in magnetic state $\uparrow$ respectively closes and opens a magnetic field-effect transistor 1 when exhibiting n-type carrier behaviour and respectively opens and closes the magnetic field-effect transistor 1 when exhibiting p-type carrier behaviour.

When the transistor 1 is in magnetic state $\leftarrow$ the conductance state remains unchanged. The n-type remains always ON and the p-type always OFF or *vice versa,* depending on the sign of the chemical potential shift.

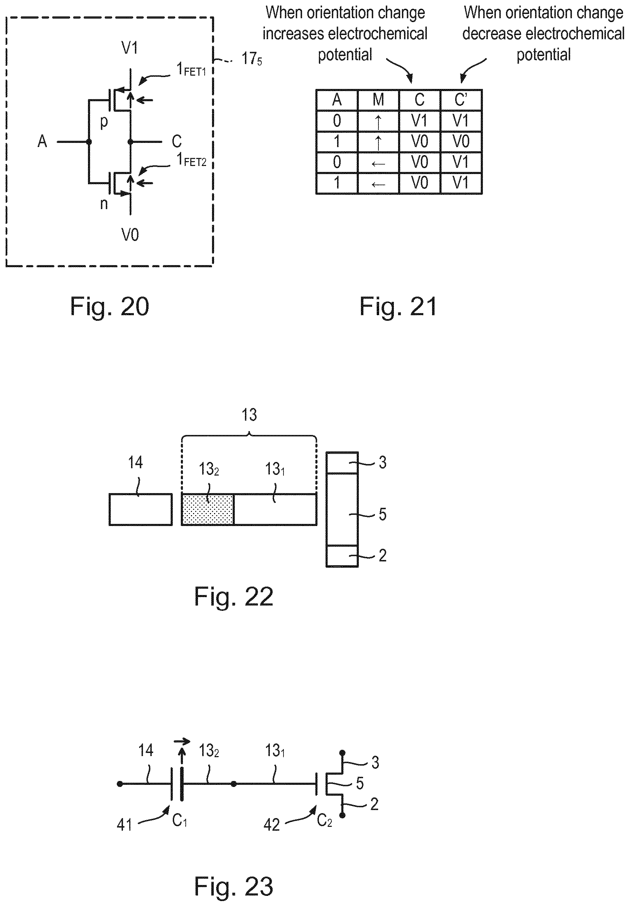

Figure 20 shows an inverter $17_6$ based on two magnetic field-effect transistors $1_{FET1}$, $1_{FET2}$ having opposite channel conductivities.

A first magnetic field-effect transistor $1_{FET1}$ may have a p-type channel and a second magnetic field-effect transistor $1_{FET2}$ may have a n-type channel. Both transistors $1_{FET1}$, $1_{FET2}$ may share the same magnetically-ordered gate and each transistor $1_{FET1}$, $1_{FET2}$ has an additional electrostatic gate to allow independent adjustment of their respective working points.

Referring also to Figure 21, magnetization orientation may be seen as an additional logic input with $\uparrow$ corresponding to logic '0' and $\leftarrow$ corresponding to logic '1'. Thus, the magnetically-controllable inverter $17_6$ realises a NOR logic function using only two magnetic field-effect transistors $1_{FET1}$, $1_{FET2}$.

### Floating gate and remote region of magnetically-ordered material

Referring to Figures 22 and 23, a magnetic transistor 1, which may be, for example a single-electron transistor or a field-effect transistor, may comprise a floating gate 13 and a control electrode 14.

The magnetic transistor 1 includes first and second capacitors 41, 42 are formed. The first capacitor 41 is formed by the floating gate 13 and control electrode 14 and has a capacitance C1. The second capacitor 42 is formed by the floating gate 13 and conductive path 5 and has a capacitance $C_s$.

Although the conductive path 5 is shown in Figure 22 as a block between contacts 2, 3, it need not be continuous and may, for example, include at least one conductive island and at least two tunnel barriers.

Likewise, although a circuit symbol for a MOSFET is used in Figure 23, it need not be a MOSFET, but can be, for example, a single-electron transistor having a conductive path which includes at least one conductive island and at least two tunnel barriers.

As shown in Figure 22, a first part $13_1$ of the floating gate 13 which is closest to the conductive path 5 is formed from a non-magnetically-ordered material, such as n-type polysilicon (or other doped semiconductor material) or a normal metal, and a second part $13_2$ which is further away from the channel 5 which comprises a magnetically-ordered material, such as iridium manganese (IrMn) or other an antiferromagnetic material, a ferromagnetic material or a ferrimagnetic material.

The second part $13_2$ of the floating gate 13 forms one plate of the first capacitor 41. The first capacitor 41 is referred to as the "magnetic capacitor". The second capacitor 42 is referred to as the "gate capacitor".

The electrochemical potential, although constant within the floating gate 13, can vary since it is not bound to a reservoir. However, both the control electrode 14 and the transistor channel 5 are connected to reservoir and so electrochemical potentials of the control electrode 14 and channel 5 are fixed.

When reorienting the magnetic moment in the magnetic capacitor 41, the chemical potential changes by $\Delta\mu_C = \mu_C(M_1) - \mu_C(M_2)$ where M1 and M2 are initial and final magnetization orientations (i.e. vector quantities).

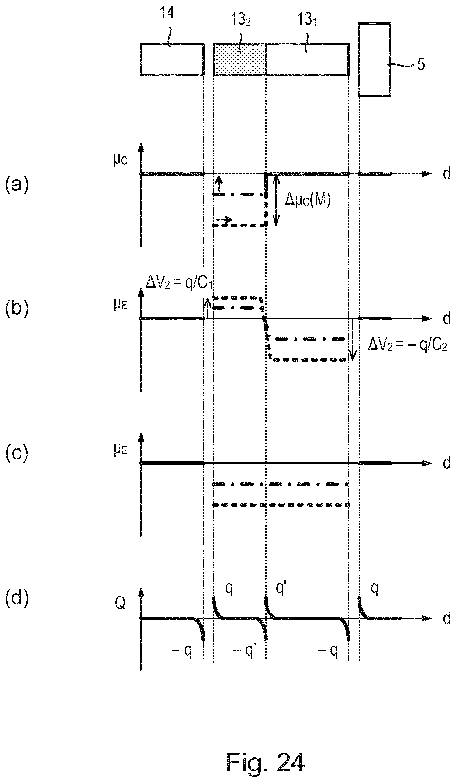

Referring also to Figure 24, the electrical potential $\mu_C$ varies to equalize the electrochemical potential in the floating gate 13. The corresponding voltage drop $\Delta V$ is divided between the two capacitors 41, 42 corresponding to:

$$\Delta\mu_C/e = q(C_1^{-1} + C_2^{-1}) = \Delta V_1 + \Delta V_2 \qquad (3)$$

For an efficient voltage division where most of the voltage drop is over the gate capacitor 42, it is preferable that $C_1 >> C_2$. The charge q accumulated in the capacitors 41, 42 is given by:

$$q = C_1.C_2/(C_1 + C_2) \, \Delta\mu_C/e \qquad (4)$$

Thus, if $C_1 >> C2$, then equation (4) becomes:

$$q \approx C_2.\Delta\mu_C \qquad (4')$$

If the magnetic part of the electrode $13_2$ were connected to the control electrode reservoir instead of to the floating lead, additional charges would flow on or off the magnetic part of the electrode $13_2$ to equalize the electrochemical potential with the electrochemical potential of the gate reservoir $eV_G$ at gate voltage bias $V_G$. A corresponding electric potential drop over the two capacitors 41, 42 follows same magnitude given in equation (1) above, but is of opposite sign. The same potential variation occurs if the magnetic region $13_2$ is part of the transistor gate capacitor 42 connected to the floating lead. Magnitude of potential shifts are equal, but of opposite sign compared to the case where the magnetic region $13_2$ is on the other end of the floating gate 13. It is noted that the magnetic charge redistribution of an embedded magnetic regions sandwiched between nonmagnetic regions of thicknesses larger than the depletion layer thickness would be screened and would not affect the conductivity of the transistor channel 5. Thus, the magnetically-ordered material should be disposed at an interface with either the gate dielectric 8 or gap (not shown) or control gate dielectric 15 or gap (not shown).

The magnetic capacitor 42 may be connected to more than one non-magnetic transistor and can simultaneously control their conductivities.

Fabrication

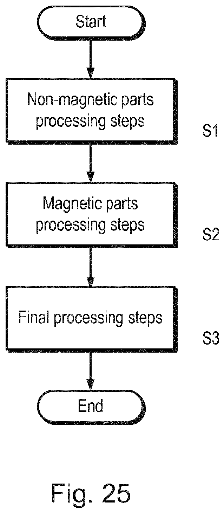

Referring to Figures 3 and 25, a method of fabricating a magnetic transistor and a logic circuit which includes one or more magnetic transistors is shown.

Non-magnetic parts of the transistor, including non-magnetically-ordered part $13_1$ of the floating gate 13 and even the control gate dielectric 15 and the control electrode 14, are fabricated (step S1). This can be carried out in a CMOS fabrication plant using known fabrication techniques.

Once the non-magnetic parts of the transistor of have been fabricated, magnetic parts of the transistor, specifically the magnetically-ordered part $13_2$ of the floating gate 13, can be fabricated (step S2). This can be carried out in separate part of the plant, thereby helping to avoid contamination of the CMOS fabrication plant.

Finally, back-end processing steps can be carried out (step $S_3$).

Modifications

It will be appreciated that many modifications may be made to the embodiments hereinbefore described.

Magnetic transistors and/or non-magnetic transistors need not be lateral devices, i.e. devices in which charge transport takes place generally in plane or parallel to layers forming the device or, expressed differently, generally perpendicular to the direction of layer formation. The magnetic transistors and/or non-magnetic transistors may be vertical devices, i.e. takes place generally in perpendicular to layers forming the device (along the direction of layer formation).

**Claims**

1. A controllable conduction device comprising:

   a conduction path (5);
   a floating gate (13) for controlling flow of charge carriers along the conduction path, the floating gate comprising:

      a first floating gate part ($13_1$); and
      a second floating gate part ($13_2$),
      wherein the first floating gate part comprises a non-magnetically-ordered material and which is disposed closer to the conduction path than the second floating gate part; and the second floating gate part is disposed further away from the conduction path than the first floating gate part and which is conductively coupled to the first floating gate part;
      a control electrode (14) which comprises a non-magnetically-ordered material and which is capacitively coupled to the second floating gate part;
      **characterised in that** the second floating gate part comprises a magnetically-ordered material.

2. A device according to claim 1, wherein the first floating gate part ($13_1$) comprises a semiconductor material.

3. A device according to claim 1 or 2, wherein the second floating gate part ($13_2$) comprises a ferromagnetic material.

4. A device according to claim 1 or 2, wherein the second floating gate part ($13_2$) comprises an antiferromagnetic material.

5. A device according to any preceding claim, wherein the floating gate (13) is elongate.

6. A device according any preceding claim, wherein the conduction path (5) comprises a semiconductor material.

7. A device according to any preceding claim, wherein the device is a field-effect transistor.

8. A device according to any preceding claim, wherein the device is correlated charge transfer device.

**9.** A circuit comprising:
at least two controllable conduction devices (1) according to any one of claims 1 to 8, which share a common, second floating gate part.

**Patentansprüche**

**1.** Steuerbare Leitungsvorrichtung, umfassend:

einen Leitungspfad (5);
ein Floating-Gate (13) zur Steuerung des Flusses von Ladungsträgern entlang des Leitungspfads, wobei das Floating-Gate folgendes umfasst:

einen ersten Floating-Gate-Teil ($13_1$); und
einen zweiten Floating-Gate-Teil ($13_2$),
wobei der erste Floating-Gate-Teil ein nicht magnetisch geordnetes Material umfasst, und wobei er näher an dem Leitungspfad angeordnet ist als der zweite Floating-Gate-Teil; und wobei der zweite Floating-Gate-Teil weiter von dem Leitungspfad entfernt angeordnet ist als der erste Floating-Gate-Teil, und wobei er leitfähig mit dem ersten Floating-Gate-Teil gekoppelt ist;

eine Steuerelektrode (14), die ein nicht magnetisch geordnetes Material umfasst, und die mit dem zweiten Floating-Gate-Teil kapazitiv gekoppelt ist;
**dadurch gekennzeichnet, dass** der zweite Floating-Gate-Teil ein magnetisch geordnetes Material umfasst.

**2.** Vorrichtung nach Anspruch 1, wobei der erste Floating-Gate-Teil ($13_1$) ein Halbleitermaterial umfasst.

**3.** Vorrichtung nach Anspruch 1 oder 2, wobei der zweite Floating-Gate-Teil ($13_2$) ein ferromagnetisches Material umfasst.

**4.** Vorrichtung nach Anspruch 1 oder 2, wobei der zweite Floating-Gate-Teil ($13_2$) ein antiferromagnetisches Material umfasst.

**5.** Vorrichtung nach einem der vorstehenden Ansprüche, wobei das Floating-Gate (13) länglich ist.

**6.** Vorrichtung nach einem der vorstehenden Ansprüche, wobei der Leitungspfad (5) ein Halbleitermaterial umfasst.

**7.** Vorrichtung nach einem der vorstehenden Ansprüche, wobei die Vorrichtung ein Feldeffekttransistor ist.

**8.** Vorrichtung nach einem der vorstehenden Ansprüche, wobei die Vorrichtung eine korrelierte Ladungsübertragungsvorrichtung ist.

**9.** Schaltung, umfassend:
mindestens zwei steuerbare Leitungsvorrichtungen (1) nach einem der Ansprüche 1 bis 8, die sich einen gemeinsamen zweiten Floating-Gate-Teil teilen.

**Revendications**

**1.** Dispositif à conduction régulable comprenant :

un trajet de conduction (5) ;
une porte flottante (13) pour réguler le flux de porteurs de charge le long du trajet de conduction, la porte flottante comprenant :

une première partie de porte flottante ($13_1$) ; et
une seconde partie de porte flottante ($13_2$),
la première partie de porte flottante comprenant un matériau non ordonné magnétiquement et qui est disposé plus près du chemin de conduction que la seconde partie de porte flottante ; et la seconde partie de porte flottante étant disposée plus loin du chemin de conduction que la première partie de porte flottante et étant accouplée de façon conductrice à la première partie de porte flottante ;

une électrode de commande (14) qui comprend un matériau non ordonné magnétiquement et qui est accouplée de manière capacitive à la seconde partie de porte flottante ;
**caractérisé en ce que** la seconde partie de porte flottante comprend un matériau ordonné magnétiquement.

2. Dispositif selon la revendication 1, la première partie de porte flottante ($13_1$) comprenant un matériau semi-conducteur.

3. Dispositif selon la revendication 1 ou 2, la seconde partie de porte flottante ($13_2$) comprenant un matériau ferromagnétique.

4. Dispositif selon la revendication 1 ou 2, la seconde partie de porte flottante ($13_2$) comprenant un matériau antiferromagnétique.

5. Dispositif selon l'une quelconque des revendications précédentes, la porte flottante (13) étant allongée.

6. Dispositif selon l'une quelconque des revendications précédentes, le trajet de conduction (5) comprenant un matériau semi-conducteur.

7. Dispositif selon l'une quelconque des revendications précédentes, le dispositif étant un transistor à effet de champ.

8. Dispositif selon l'une quelconque des revendications précédentes, le dispositif étant un dispositif de transfert de charge corrélée.

9. Circuit, comprenant :
au moins deux dispositifs de conduction régulables (1) selon l'une quelconque des revendications 1 à 8, qui partagent une seconde partie de porte flottante commune.

Fig. 1

Fig. 2

Fig. 3

Re-configurable logic circuit

Magnetic controllable conduction device(s) — 1

— 17

Resistor(s) ---- 18

Non-magnetic controllable conduction device(s) ---- 19

Fig. 4

$1_{SET}$

$V_G$

M ↗ — 4

$C_G$

7   7

$V_S$   $V_D$

2   3

6

Fig. 5

p-type | n-type

G

ST

CB

$V_{G1}$ $V_{G2}$   $V_G$

Fig. 6

Dependency of output state (i.e. ON and OFF) on input state
(i.e. 0 and 1) of a reconfigurable single-electron transistor $1_{SET}$

## Fig. 7

Fig. 8

Fig. 9

Fig. 10

Fig. 12

Fig. 13

Fig. 14

Fig. 15

Fig. 16

Fig. 17a

Fig. 17b

Fig. 18a

Fig. 18b

Fig. 19

Fig. 20

When orientation change increases electrochemical potential → / When orientation change decrease electrochemical potential →

| A | M | C | C' |
|---|---|---|---|
| 0 | ↑ | V1 | V1 |
| 1 | ↑ | V0 | V0 |
| 0 | ← | V0 | V1 |
| 1 | ← | V0 | V1 |

Fig. 21

Fig. 22

Fig. 23

Fig. 24

Fig. 25

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2068350 A1
- US 20100182837 A1
- US 20080265243 A1
- EP 1830410 A1
- EP 2631912 A1